# EUROPÄISCHE PATENTSCHRIFT

(11) **EP 0 400 372 B1**
(45) Veröffentlichungstag und Bekanntmachung des Hinweises auf die Patenterteilung: **02.08.1995**
(21) Anmeldenummer: 90108832.8
(22) Anmeldetag: 10.05.1990
(51) Int. Cl.: H03K 19/0175

(54) **CMOS-ECL-Wandler**
CMOS/ECL converter
Convertisseur CMOS-ECL

(30) Priorität: 30.05.1989 DE 3917538
(43) Veröffentlichungstag der Anmeldung: 05.12.1990
(73) Patentinhaber: SIEMENS AKTIENGESELLSCHAFT, 80333 München (DE)
(72) Erfinder: Stegherr, Michael, Dr., D-8014 Neubiberg (DE)

(56) Entgegenhaltungen:
- EP-A- 0 239 841
- DE-A- 2 654 082
- 1982 IEEE INTERNATIONAL SOLID-STATE CIRCUITS CONFERENCE, 12. Februar 1982,Seiten 248-249, New York, US; E.L. HUDSON et al.: "An ECL compatible 4K CMOS RAM"
- PATENT ABSTRACTS OF JAPAN, Band 9, Nr. 140 (E-321)[1863], 14. Juni 1985 JP-A-60 21 620
- IEEE 1987 SOLID-STATE CIRCUITS CONFERENCE, Band 30, Februar 1987, Seiten 56-57,338, New York, US; P.-H. YEUNG et al.: "A 300MHz bipolar-CMOS video shift register with FIFO"
- PATENT ABSTRACTS OF JAPAN, Band 14, Nr. 65 (E-884)[4008], 6. Februar 1990; JP-A-1 284 114

## Beschreibung

Die Erfindung betrifft einen CMOS-ECL-Wandler nach dem Oberbegriff des Patentanspruchs 1.

ECL- und CMOS-Schaltungen sind in der Halbleiterschaltungstechnik weit verbreitet. Dabei besitzen die ECL-Schaltungen (= emittergekoppelte Logik) die kleinsten Schaltzeiten aller Logikfamilien. Diese liegen im Bereich von wenigen Nanosekunden und reichen zum Teil auch unter eine Nanosekunde. In CMOS-Schaltungen werden komplementäre MOSFET-Transistoren eingesetzt. Dabei ist die ohmige Ausgangsbelastung der CMOS-Schaltungen wegen der hohen Eingangswiderstände sehr gering. Je größer dabei die kapazitive Ausgangsbelastung ist, desto größer wird auch die Schaltzeit. Bei größerer kapazitiver Ausgangslast liegt diese in der Größenordnung von etwa 10 Nanosekunden und darüber.

Neben der MOS-Schaltungstechnik hat sich in den letzten Jahren eine Bipolar-CMOS-(BICMOS)-Schaltungstechnologie entwickelt, die besonders bei zeitkritischen und kompakten Schaltungen eingesetzt wird. Durch die Verwendung von BICMOS-Schaltungen ergeben sich Vorteile aus der MOS- als auch aus der Bipolar-Schaltungstechnologie. Hohe Packungsdichten und kleine statische Verlustleistung, welche beispielsweise für Schaltungen aus der CMOS-Schaltungstechnik charakteristisch sind, eine geringe Offsetspannung, sowie eine sehr hohe Verarbeitungsgeschwindigkeit, welche für Schaltungen in ECL bzw. Bipolarschaltungstechnik kennzeichnend sind, sind Merkmale, die für eine Verwendung von Schaltungen in "BICMOS" Schaltungstechnologie sprechen. Mit Hilfe der "BICMOS" Schaltungstechnologie können mithin sehr hohe Arbeitsgeschwindigkeiten erreicht werden, in dem man die Schaltungsteile mit höherer Verarbeitungsgeschwindigkeit in ECL-Technik realisiert, zeitunkritischere Schaltungsteile dagegen in CMOS-Schaltungstechnik.

Zwischen diesen beiden Schaltungsblöcken sind jeweils schnelle Pegelwandler bzw. Ausgangstreiberschaltungen erforderlich.

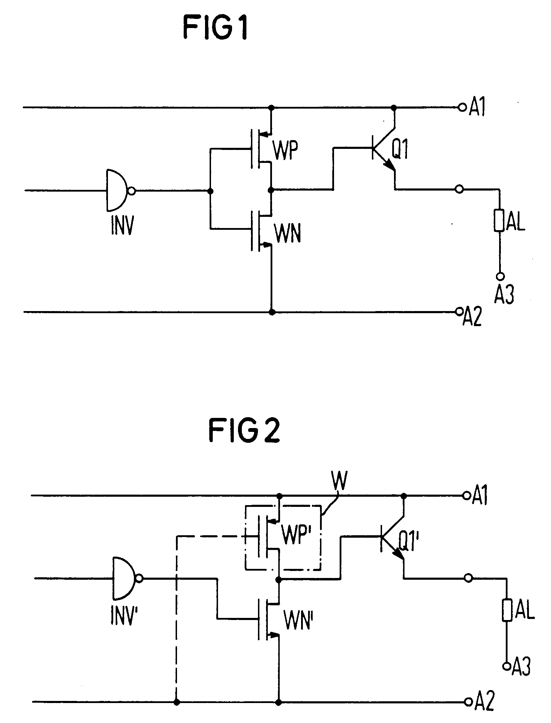

Figur 1 zeigt hierbei einen zum Stand der Technik gehörenden CMOS-Ausgangstreiber in "BICMOS" Schaltungstechnik, der CMOS-in ECL-Pegel wandelt. Er enthält eine Treiberstufe mit nachgeschalteten bipolaren Ausgangstransistor. Wie weiter aus der Figur 1 ersichtlich ist, ist der CMOS-ECL-Ausgangstreiber eingangsseitig mit einem chipinternen CMOS-Standardinverter beschaltet und ausgangsseitig mit einer Ausgangslast von 50 Ohm abgeschlossen. Die Anpassung zwischen dem chipinternen CMOS-Standardinverter mit geringen Kanalweiten und dem bipolaren Ausgangstransistor geschieht hier durch einen geeignet zu dimensionierenden CMOS Inverter als Treiberstufe. Bei großen MOS-Transistorweiten dieses Treibers ist zwar der zu liefernde Basisstrom für den Ausgangstransistor ausreichend groß, aber gleichzeitig wird der chipinterne CMOS-Standardinverter vor der Treiberstufe kapazitiv stark belastet.

Aus dem Patent Abstract of Japan, Band 9, Nr. 140 (E-321) (1863), 14. Juni 1985 bzw. der japanischen Patentanmeldung 60-21620 ist darüber hinaus eine integrierte Schaltung bekannt, die eine Treiberstufe mit nachgeschaltetem Feldeffekttransistor aufweist, wobei die Treiberstufe aus einem Feldeffekttransistor und einem Lastwiderstand besteht, der so dimensioniert ist, daß der Feldeffekttransistor des Treibers im Sättigungsgebiet betrieben wird und dadurch aufgrund der damit verbundenen geringeren Eingangskapazität eine höhere Schaltgeschwindigkeit erzielbar ist.

Ferner ist aus der deutschen Offenlegungsschrift 26 54 082 bekannt, daß ein Lastwiderstand durch einen p-Kanal-Transistor realisierbar ist, wobei dessen Steuerelektrode mit Bezugspotential verbunden ist.

Der Erfindung liegt daher die Aufgabe zugrunde einen ECL-CMOS-Wandler vorzustellen bei dem die kapazitive Belastung eingangsseitiger Schaltungen möglichst gering ist.

Diese Aufgabe wird durch die kennzeichnenden Merkmale des Patentanspruchs 1 gelöst.

Die mit der Erfindung erzielten Vorteile bestehen darin, daß die Verarbeitungszeiten zum Wandeln von CMOS in ECL-Pegel gering sind, so daß durch die Anwendung der erfindungsgemäßen Schaltung ein Geschwindigkeitsgewinn gegenüber CMOS-ECL-Wandler nach dem Stand der Technik erzielt werden kann. Zur Herstellung des CMOS-ECL-Wandlers kann hierbei ein "BICMOS" Prozeß herangezogen werden, der neben p- und n-Kanal MOS Transistoren isolierte npn-Bipolartransistoren liefert. Eine solche Technologie ist der Schutzrechtanmeldung von E. P. Jacobs und J. Winnerl "Verfahren zum gleichzeitigen Herstellen von bipolaren und komplementären MOS-Transistoren auf einem gemeinsamen Siliziumsubstrat (GR 85 P 1343 DE, P 35 19 79 0.0, B 85 16 16 1.6) entnehmbar.

Weitere Ausgestaltungen des erfindungsgemäßen CMOS-ECL-Wandlers sind Gegenstand der Unteransprüche 2 bis 4 und werden dort ausführlich wiedergegeben.

Ein Ausführungsbeispiel der Erfindung ist in der Zeichnung Figur 2 dargestellt und wird im folgenden näher beschrieben. Es zeigen dabei:
- Figur 1: einen zum Stand der Technik gehörenden CMOS-ECL-Wandler,
- Figur 2: eine Realisierung des erfindungsgemäßen CMOS-ECL-Wandlers.

Treiberschaltungen zum Wandeln von CMOS-ECL-Pegel sind Stand der Technik und beispielsweise in der Veröffentlichung von Hudson et al: "An ECL compatible 4K CMOS RAM", ISSCC Digest of Technical Papers, Februar 1982 auf der Seite 248 und in dem US Patent von Hudson et al "ECL Compatible CMOS Memory", Intel, US-P-4.437.171 vom 13. März 1984. In beiden Druckschriften findet man Treiberschaltungen in "BICMOS" Schaltungstechnik, wobei die Figur 1 in den vorliegenden Anmeldungsunterlagen der Figur 3 der Veröffentlichung von Hudson et al "ECL Compatible 4 K CMOS RAM" entnommen ist. Nach Figur 1 enthält der vorliegende CMOS-ECL-Wandler eine Treiberstufe sowie einen daran angeschlossenen Ausgangstransistor Q1. Eingangsseitig ist der CMOS-ECL-Wandler mit einem Inverter INV beschaltet, während der Ausgang des Wandlers mit einer Ausgangslast AL abgeschlossen ist. Die Treiberstufe enthält einen P- und einen N-Kanal Feldeffekttransistor WP,WN, die gemeinsam eine Serienschaltung bilden. Ein erster Anschluß dieser Serienschaltung ist hierbei mit einem ersten Anschlußpunkt zur Spannungsversorgung A1 und ein zweiter Anschluß der Serienschaltung mit einem zweiten Anschlußpunkt A2 zur Spannungsversorgung verbunden. Im vorliegenden Fall ist der erste Anschlußpunkt A1 mit 0 Volt und der zweite Anschußpunkt A2 mit - 5 Volt zu beschalten. Der Gateanschluß des P-Kanal des Feldeffekttranssistor WP und der Gateanschluß des N-Kanal des Feldeffekttransistors WN bilden gemeinsam den Eingang der Treiberstufe und gleichzeitig den Eingang des CMOS-ECL-Wandlers. Auf diesen ist der chipinterne Standardinverter INV geschaltet. Der erste Anschluß der Serienschaltung ist mit einem ersten Anschluß des P-Kanalfeldeffekttransistors WP und der zweite Anschluß der Serienschaltung mit einem ersten Anschluß des N-Kanal Feldeffekttransistors WN verbunden. Der zweite Anschluß des P-Kanal Feldeffekttransistors WP, sowie der zweite Anschluß des N-Kanal-Feldeffektransistors WN bilden gemeinsam den Ausgang der Treiberstufe und sind mit dem Steuereingang (Basisanschluß) des Ausgangstransistors Q1 zu verschalten. Der Ausgangstransistor Q1 selbst ist zwischen dem ersten Anschlußpunkt zur Spannungsversorgung A1 und dem Ausgang des CMOS-ECL-Wandlers angeordnet, sodaß der Kollektoranschluß von Q1 mit A1 und der Emitteranschluß von Q1 mit dem Ausgang des Wandlers verbunden ist. Der Ausgangstransistor Q1 nach Figur 1 ist als NPN Bipolartransistor ausgeführt, über den eine Ausgangslast AL mit einem Wellenwiderstand von 50 Ohm an einen dritten Anschlußpunkt A3 angeschlossen ist. Der dritte Anschlußpunkt A3 ist hierbei mit einer Spannung von - 2 Volt zu beschalten. Die Ausgangslast AL ergibt sich beispielsweise durch die Eingangsstufe einer nachfolgenden Schaltung einschließlich der hierfür benötigten Zuleitungen. Die Anpassung zwischen dem chipinternen CMOS-Standardinverter INV mit geringen Kanalweiten beispielsweise von 10 »m/5 »m für den P-bzw. N-Kanal Feldeffekttransistors des Standardinverters und dem bipolaren Ausgangstransistors Q1 geschieht hier durch einen geeignet zu dimensionierenden CMOS Inverter als Treiberstufe. Bei großen MOS-Transistorweiten dieses Treibers ist zwar, wie eingangs bereits angegeben, der zu liefernde Basisstrom für den Ausgangstransistor Q1 ausreichend groß, jedoch wird gleichzeitig der chipinterne Standardinverter INV vor der Treiberstufe kapazitiv stark belastet.

Am Eingang des CMOS-ECL-Wandlers werden CMOS Pegel zwischen 0 und - 5 Volt angelegt, und in einen ECL-Pegel von ungefähr - 2 Volt für ein Lowsignal und - 1,2 Volt für ein Highsignal gewandelt. Liegt an dem Eingang des CMOS-ECL-Wandlers ein Signal an, welches ungefähr - 2,5 Volt unterschreitet, so leitet der P-Kanal Feldeffekttransistor WP und der N-Kanal Feldeffekttransistor WN der Treiberstufe sperrt. Dies hat weiter zu Folge, daß der Ausgangstransistor Q1 leitet und ein Ausgangssignal über die Ausgangslast AL geführt wird. Die Zeitspanne in der die beiden Feldeffektransistoren der Treiberstufe umschalten und in der der Ausgangstransistor Q1 in den leitenden Zustand versetzt wird, bezeichnet man als Verzögerungszeit. Bei einer geeigneten Wahl der Transistorweiten des Treibers beispielsweise für den P-Kanal Feldeffekttransistor von 50 »m und für den N-Kanal Feldeffekttransistor 5 »m kann die Verzögerungszeit zwischend dem Ein- und Ausgang des Wandlers im Bereich von 1,65 Nanosekunden liegen. Überschreitet der Spannungspegel am Eingang des CMOS-ECL-Wandlers einen Spannungswert von - 2,5 Volt, so tritt der umgekehrte Effekt ein und der N-Kanal Feldeffekttransistor WN leitet, während der P-Kanal-Feldeffekttransistor WP sperrt. In diesem Falle ist auch der Ausgangstransistor Q1 gesperrt und am Ausgang des CMOS-ECL-Wandlers liegt eine Spannung von - 2 Volt.

Als ein Dimensionierungsbeispiel könne folgende Angaben für die Kanalweiten der Feldeffekttransistoren angesehen werden. Für den chipinternen Standardinverter INV läßt sich eine Kanalweite für den P-Kanal Feldeffekttransistor von 10 »m und für den N-Kanal Feldeffektransistor von 5 »m angeben (beide Feldeffekttransistoren des chipinternen Standardinverters sind in der Figur 1 nicht eingezeichnet). Für die Treiberstufe läßt sich als Kanalweite für den P-Kanal Feldeffekttransistor 50 »m und für den N-Kanal Feldeffekttransistor 5 »m wählen. Hieraus ergibt sich eine Verzögerungszeit von ungefähr 1,65 Nanosekunden bei einer maximalen Frequenz von 220 Megahertz. Die Ausgangslast AL sollte einen Wert von 50 OHM haben, so daß der Spannungshub U über der Ausgangslast ungefähr 800 Millivolt beträgt. Die Kanallänge der MOS-Transistoren sei mit 1,5 »m, die Transitfrequenz des bipolaren Transistors mit 3,5 GHz vorgegeben (technologieabhängig). Die Weiten und Längen des Bipolartransistors sind an den maximalen Laststrom anzupassen und für beide Schaltungen (Figur 1 und 2) gleich. Die angegebenen Verzögerungszeiten bzw. Maximalfrequenzen beziehen sich auf eine bestimmte BICMOS-Technologie, siehe GR 85 P 1343 DE = P 35 19 790.0.

Figur 2 zeigt eine Realisierung des erfindungsgemäßen CMOS-ECL-Wandlers, der sich gegenüber dem CMOS-ECL-Wandler nach dem Stand der Technik in Figur 1 durch eine unterschiedliche Auslegung der Treiberstufe unterscheidet. Ebenso wie in Figur 1 enthält der CMOS- ECL-Wandler eine Treiberstufe mit angeschlossenen bipolaren Ausgangstransistors Q1′. Die Treiberstufe wird in diesem Falle aus einem Widerstandselement W und einem N-Kanal Feldeffekttransistor WN′ gebildet. Beide bilden wiederum eine Serienschaltung, wobei ein erster Anschluß der Serienschaltung mit dem ersten Anschlußpunkt zur Spannungsversorgung A1 und ein zweiter Anschluß der Serienschaltung mit dem zweiten Anschlußpunkt zur Spannungsversorgung A2 verbunden ist. Der erste Anschluß der Serienschaltung stellt hierbei gleichzeitig den ersten Anschluß des Widerstandselements W dar, während der zweite Anschluß der Serienschaltung durch einen ersten Anschluß des N-Kanal Feldeffekttransistors WN′ gebildet wird. Der zweite Anschluß des Widerstandselements W und ein zweiter Anschluß des N-Kanal Feldeffekttransistors WN′ bilden gemeinsam den Ausgang der Treiberstufe die auf den Steuereingang, (Basisanschluß) des bipolaren Ausgangstransistors Q1′ geschaltet ist. Auf den Eingang des CMOS-ECL-Wandlers ist in diesem Falle wiederum ein Inverter INV′ geschaltet. Die Anpassung dieses ebenfalls chipinternen Standardinverters INV′ und dem bipolaren Ausgangstransistors Q1′ erfolgt mit Hilfe der bereits beschriebenen Treiberstufe, wobei nur der N-Kanal Feldeffekttransistor WN′ den Eingang der Treiberstufe bildet.

Als Widerstandselement W eignet sich insbesondere ein P-Kanal Feldeffekttransistor WP′, dessen Gateanschluß an den zweiten Anschlußpunkt zur Spannungsversorgung A2 anzuschließen ist und dessen erster und zweiter Anschluß den ersten und zweiten Anschluß des Widerstandselements darstellen. Wie in Figur 1 wird hierbei der erste und zweite Anschlußpunkt zur Spannungsversorgung A1, A2 mit einem Spannungswert von 0 bzw. - 5 Volt verbunden.

Der Vorteil dieser Anordnung liegt darin, daß die kapazitive Belastung des CMOS-ECL-Wandlereingangs gering ist, weil das Widerstandselement W bzw. der P-Kanal Feldeffekttransistor WP′ zu dieser Eingangsbelastung nichts beiträgt. Wie in Figur 1 ist der bipolare Ausgangstransistor Q1′ zwischen dem ersten Anschlußpunkt zur Spannungsversorgung A1 und dem Ausgang des CMOS-ECL-Wandlers angeschlossen, wobei an dessen Ausgang wiederum eine Ausgangslast AL von 50 OHM mit einem dritten Anschlußpunkt A3 verbunden ist. Der dritte Anschlußpunkt A3 ist ebenso wie in Figur 1 mit einem spannungswert von - 2 Volt zu verbinden. In der erfindungsgemäßen CMOS-ECL-Wandlerschaltung kann der Widerstandswert W bzw. die Kanalweite des P-Kanal Feldeffekttransistors WP′ so eingestellt werden, daß ein ausreichend hoher Basisstrom für den bipolaren Ausgangstransistor Q1′ geliefert werden kann. Da die Verlustleistung der gesamten Anordnung von dem geforderten Spannungshub über der Ausgangslast AL bestimmt wird, fällt eine höhere Verlustleistung im Vergleich zu CMOS-Treibern hier nicht ins Gewicht.

Die beschriebene vorteilhafte Ausgestaltung der Treiberstufe läßt sich darüber hinaus auch dann ersetzen, wenn eine andere Eingangs- bzw. Ausgangsbeschaltung des Treibers vorliegt.

Die nachfolgenden Angaben können wiederum als ein Dimensionierungsbeispiel für eine Realisierung des erfindungsgemäßen CMOS-ECL-Ausgangstreibers angesehen werden. Die Inverterdimensionierung INV′ des Feldeffekttransistors läßt sich analog wie in Figur 1 vornehmen, so daß für den P-Kanal Feldeffekttransistor eine Kanalweite von 10 »m und für den N-Kanal Feldeffekttransistor eine Kanalweite von 5 »m ausreicht. Für den N-Kanal Feldeffekttransistor WN′ läßt sich eine Kanalweite von 20 »m angeben und bei einer Realisierung des Wiederstandselements W durch ein P-Kanal Feldeffekttransistor WP′ sollte die Kanalweite desselbigen bei etwa 60 »m liegen. Hieraus ergibt sich dann eine Verzögerungszeit von ungefähr 1.0 Nanosekunden, so daß sich ein Geschwindigkeitsgewinn von 60 Prozent gegenüber dem CMOS-ECL-wandler nach Figur 1 erzielen läßt. Als maximal mögliche Einsatzfrequenz sei hier 350 Megahertz angegeben. Analog wie in Figur 1 beträgt die Ausgangslast AL′50 OHM wodurch ein Spannungshub von ungefähr 800 Millivolt über der Ausgangslast erzeugt wird. Die Kanallänge der MOS-Transistoren sei mit 1,5 »m und die Transitfrequenz des Bipolartransistors mit 3,5 GHz vorgegeben (wiederum technologieabhängig). Die angegebenen Verzögerungszeiten bzw. Maximalfrequenzen beziehen sich wiederum auf eine bestimmte BICMOS-Technologie, siehe GR 85 P 1343 DE = P 35 19 790.0.

## Patentansprüche

1. CMOS-ECL-Wandler mit einer Treiberstufe und einem bipolaren Ausgangstransistor (Q1, Q1′) zum Anschluß einer Ausgangslast (AL), wobei ein Eingang des CMOS-ECL-Wandlers durch einen Eingang der Treiberstufe gebildet wird und ein Ausgang der Treiberstufe mit einem Steuereingang des Ausgangstransistors (Q1, Q1′) angeschlossen ist, bei der die Treiberstufe mit einem ersten und zweiten Anschlußpunkt zur Spannungsversorgung (A1, A2) verbunden ist, bei dem der Ausgangstransistor (Q1, Q1′) zwischen einem Ausgang des CMOS-ECL-Wandlers und dem ersten Anschlußpunkt zur Spannungsversorgung (A1) geschaltet ist und die Treiberstufe mindestens einen Feldeffekttransistor eines ersten Leitungstyps (WN, WN′) enthält, dessen Gateanschluß mit dem Eingang der Treiberstufe verbunden ist und der zugleich zwischen dem Ausgang der Treiberstufe und dem zweiten Anschlußpunkt zur Spannungsversorgung (A2) angeschlossen ist, **dadurch gekennzeichnet,** daß die Treiberstufe ein Widerstandselement (W) enthält, und daß das Widerstandselement (W) zwischen dem Ausgang der Treiberstufe und dem ersten Anschlußpunkt zur Spannungsversorgung (A1) geschaltet ist und daß das Widerstandselement (W) ein Feldeffekttransistor zweiten Leitungstyps (WP′) ist, dessen Gateanschluß mit den zweiten Anschlußpunkt zur Spannungsversorgung (A2) verbunden ist.

2. CMOS-ECL-Wandler nach Anspruch 1, **dadurch gekennzeichnet,** daß der Ausgangstransistor (Q1, Q1′) ein npn-Bipolartransistor ist, daß der Steuereingang ein Basisanschluß desselbigen darstellt und ein Kollektoranschluß mit dem ersten Anschlußpunkt zur Spannungsversorgung (A1) und ein Emitteranschluß mit dem Ausgang des CMOS-ECL-Wandlers verbunden ist.

3. CMOS-ECL-Wandler nach Anspruch 1 oder 2, **dadurch gekennzeichnet,** daß zwischen dem Ausgang des CMOS-ECL-Wandlers und einem dritten Anschlußpunkt (A3) eine Ausgangslast (AL) angeschlossen ist.

4. CMOS-ECL-Wandler nach einem der vorhergehenden Ansprüche, **dadurch gekennzeichnet**, daß der Feldeffekttransistor ersten Leitungstyps ein n-Kanal- und der Feldeffekttransistor zweiten Leitungstyps ein p-Kanal-Feldeffekttransistor ist, daß der erste Anschlußpunkt zur Spannungsversorgung (A1) mit einem Bezugspotential und der zweite Anschlußpunkt zur Spannungsversorgung (A2) und der dritte Anschlußpunkt mit einer zum Bezugspotential negativen Spannung beschaltet wird, daß der Wert der Spannung am zweiten Anschlußpunkt zur Spannungsversorgung (A2) einen negativen Wert gegenüber der Spannung am dritten Anschlußpunkt (A3) aufweist.

## Claims

1. CMOS-ECL converter having a driver stage and a bipolar output transistor (Q1, Q1′) for the connection of an output load (AL), an input of the CMOS-ECL converter being formed by an input of the driver stage and an output of the driver stage being connected to a control input of the output transistor (Q1, Q1′), in which the driver stage is connected to a first and second connecting point for the voltage supply (A1, A2), in which the output transistor (Q1, Q1′) is connected between an output of the CMOS-ECL converter and the first connecting point for the voltage supply (A1) and the driver stage contains at least one field-effect transistor of a first conduction type (WN, WN′), the gate connection of said transistor being connected to the input of the driver stage and said transistor being connected at the same time between the output of the driver stage and the second connecting point for the voltage supply (A2), characterized in that the driver stage contains a resistance element (W), in that the resistance element (W) is connected between the output of the driver stage and the first connecting point for the voltage supply (A1), and in that the resistance element (W) is a field-effect transistor of a second conduction type (WP′), the gate connection of said transistor being connected to the second connecting point for the voltage supply (A2).

2. CMOS-ECL converter according to Claim 1, characterized in that the output transistor (Q1, Q1′) is an npn bipolar transistor, in that the control input represents a base connection of the said transistor and a collector connection is connected to the first connecting point for the voltage supply (A1) and an emitter connection is connected to the output of the CMOS-ECL converter.

3. CMOS-ECL converter according to Claim 1 or 2, characterized in that an output load (AL) is connected between the output of the CMOS-ECL converter and a third connecting point (A3).

4. CMOS-ECL converter according to one of the preceding claims, characterized in that the field-effect transistor of the first conduction type is an n-channel field-effect transistor and the field-effect transistor of the second conduction type is a p-channel field-effect transistor, in that the first connecting point for the voltage supply (A1) is connected to a reference potential and the second connecting point for the voltage supply (A2) and the third connecting point are connected to a voltage which is negative with respect to the reference potential, and in that the voltage across the second connecting point for the voltage supply (A2) has a negative value compared with the voltage across the third connecting point (A3).

## Revendications

1. Convertisseur CMOS-ECL comportant un étage d'attaque et un transistor (Q1, Q1′) bipolaire de sortie destiné au raccordement d'une charge (AL) de sortie, une entrée du convertisseur CMOS-ECL étant formée par une entrée de l'étage d'attaque et une sortie de l'étage d'attaque étant connectée à une entrée de commande du transistor (Q1, Q1′) de sortie, l'étage d'attaque étant relié à des premier et deuxième points de connexion à l'alimentation (A1, A2) en tension, le transistor (Q1, Q1′) de sortie étant branché entre une sortie du convertisseur CMOS-ECL et le premier point de connexion à l'alimentation (A1) en tension et l'étage d'attaque comprenant au moins un transistor à effet de champs d'un premier type de conduction (WN, WN′), dont la borne de grille est reliée à l'entrée de l'étage d'attaque et qui est connectée en même temps entre la sortie de l'étage d'attaque et le deuxième point de connexion à l'alimentation (A2) en tension, caractérisé en ce que l'étage d'attaque comprend un élément (W) résistif, l'élément (W) résistif est branché entre la sortie de l'étage d'attaque et le premier point de connexion à l'alimentation (A1) en tension et l'élément (W) résistif est un transistor à effet de champ du deuxième type de conduction (WP′), dont la borne de grille est reliée au deuxième point de connexion à l'alimentation (A2) en tension.

2. Convertisseur CMOS-ECL suivant la revendication 1, caractérisé en ce que le transistor (Q1, Q1′) de sortie est un transistor bipolaire npn, l'entrée de commande représente une borne de base de ce transistor et une borne de collecteur est reliée au premier point de connexion à l'alimentation (A1) en tension et une borne d'émetteur est reliée à la sortie du convertisseur CMOS-ECL.

3. Convertisseur CMOS-ECL suivant la revendication 1 ou 2, caractérisé en ce qu'une charge (AL) de sortie est connectée entre la sortie du convertisseur CMOS-ECL et un troisième point (A3) de connexion.

4. Convertisseur CMOS-ECL suivant l'une des revendications précédentes, caractérisé en ce que les transistors à effet de champ du premier type est un transistor à effet de champ à canal n et le transistor à effet de champ du deuxième type est un transistor à effet de champ à canal p, le premier point de connexion à l'alimentation (A1) en tension est porté à un potentiel de référence, le deuxième point de connexion à l'alimentation (A2) en tension et le troisième point de connexion sont portés à une tension négative par rapport au potentiel de référence et la valeur de la tension au deuxième point de connexion à l'alimentation (A2) en tension a une valeur négative par rapport à la tension au troisième point (A3) de connexion.
